(19) Europäisches Patentamt
European Patent Office
Office européen des brevets

(11) **EP 3 211 644 A1**

(12) **EUROPÄISCHE PATENTANMELDUNG**

(43) Veröffentlichungstag:
**30.08.2017 Patentblatt 2017/35**

(51) Int Cl.:
***H01C 7/12*** *(2006.01)* ***G01R 15/16*** *(2006.01)*

(21) Anmeldenummer: **17154841.5**

(22) Anmeldetag: **06.02.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **26.02.2016 DE 102016203109**

(71) Anmelder: **Siemens Aktiengesellschaft 80333 München (DE)**

(72) Erfinder:
• **Göhler, Reinhard 13503 Berlin (DE)**
• **Meppelink, Jan 59494 Soest (DE)**

(54) **ÜBERSPANNUNGSABLEITER MIT MITTELN ZUM MESSEN TRANSIENTER ÜBERSPANNUNGEN**

(57) Um einen Überspannungsableiter (1) zum Schutz elektronischer Hochspannungsgeräte mit einem Ableitergehäuse (2), einem Hochspannungsanschluss (4) und einem Erdspannungsanschluss (6), die über einen Ableiterstrompfad (9) miteinander verbindbar sind, einem in dem Ableiterstrompfad (9) angeordneten nichtlinearen Widerstand (10), der aus einer Reihenschaltung nichtlinearer Teilwiderstände (10a,10b,10c,10d,10e, 10f) gebildet ist, bereitzustellen, mit dem schnelle transiente Überspannungen einfach und kostengünstig erfasst werden können, wird vorgeschlagen, dass Spannungserfassungsmittel (12), die zum Erfassen einer an einem Messwiderstand (10e,10f) abfallenden Spannung eingerichtet sind, wobei der Messwiderstand (10e,10f) aus einem oder mehreren nichtlinearen Teilwiderständen gebildet ist.

FIG 1

## Beschreibung

Die Erfindung betrifft einen Überspannungsableiter zum Schutz elektrischer Hochspannungsgeräte mit einem Ableitergehäuse, einem Hochspannungsanschluss und einem Erdspannungsanschluss, die über einen Ableiterstrompfad miteinander verbunden sind, und einem in dem Ableiterstrompfad angeordneten nichtlinearen Widerstand, der aus einer Reihenschaltung nichtlinearer Teilwiderstände gebildet ist.

Die Erfindung betrifft auch ein Verfahren zum Messen einer an einen Überspannungsableiter abfallenden Spannung.

Der eingangs beschriebene Überspannungsableiter ist beispielsweise aus der DE 10 2012 217 310 A1 bereits bekannt. Der dort offenbarte Überspannungsableiter weist ein fluiddichtes metallisches druckfestes Ableitergehäuse auf, das mit einem Hochspannungsanschluss und einem Erdspannungsanschluss ausgerüstet ist. Der Hochspannungsanschluss ist mit dem besagten Erdspannungsanschluss über einen Ableiterstrompfad verbunden, in dem ein nichtlinearer Widerstand in Gestalt einer Varistorsäule angeordnet ist. Die Varistorsäule besteht aus einer Reihenschaltung von Varistoren, die in dem Sinne nichtlineare Widerstände bilden, als dass sie bei der Betriebsspannung eine sehr hohe Impedanz aufweisen. Übersteigt jedoch die an ihnen anliegende Spannung einen materialabhängigen Schwellenwert, weisen die Varistoren und somit der gesamte nichtlineare Widerstand eine hohe Leitfähigkeit auf. Überspannungen, die den besagten Schwellenwiderstand überschreiten, können so kontrolliert abgebaut werden. Kostenintensive Hochspannungsapparate, wie Transformatoren, Reaktoren, Strom- und Spannungswandler, Trennschalter, Hochspannungsdurchführungen, Kompensationsanlagen oder dergleichen, werden daher durch den Überspannungsableiter geschützt. Neben den beschriebenen Überspannungen, die beispielsweise bei Blitzeinschlägen auftreten, können auch so genannte schnelle transiente Überspannungen (very fast transitions (VFT)) im Netz angeordnete Hochspannungsapparate beschädigen. Transiente Überspannungen treten beispielsweise als Folge von Schalthandlungen auf. Durch Messungen der VFT im Hochspannungsnetz am Ort ihres Entstehens lassen sich Informationen über das Verhalten von Hochspannungsleistungsschaltern gewinnen, auf deren Grundlage Maßnahmen zur Schadensbegrenzung ergriffen werden können.

Um transiente Überspannungen zu messen, werden gemäß dem Stand der Technik Freiluftschaltanlagen oder gasisolierte Schaltanlagen mit einem speziell hierfür abgestimmten Spannungsteiler ausgerüstet. Das Einbringen eines separaten Spannungsteilers in bestehende Anlagen ist jedoch aufwändig und erfordert die Beachtung von Sicherheitsabständen, die oftmals nicht gegeben sind. Eine Spannungsmessung an Hochspannungsdurchführungen mit kapazitiver Steuerung ermöglicht zwar den Abgriff einer heruntergeteilten Spannung an der erdnahen Seite der Hochspannungsdurchführung. Kapazitiv gesteuerte Durchführungen weisen jedoch ein Wanderwellenverhalten auf, wodurch die Messgenauigkeit für transiente Überspannungen herabgesetzt ist.

Aufgabe der Erfindung ist es daher, einen Überspannungsableiter der eingangs genannten Art zu schaffen, mit dem schnelle transiente Überspannungen einfach und kostengünstig erfasst werden können beziehungsweise transiente Überspannungen kostengünstig zu erfassen.

Die Erfindung löst diese Aufgabe durch Spannungserfassungsmittel, die zum Erfassen einer an einem Messwiderstand abfallenden Spannung eingerichtet sind, wobei der Messwiderstand aus einem oder mehreren nichtlinearen Teilwiderständen gebildet ist.

Der erfindungsgemäße Überspannungsableiter ist mit Spannungserfassungsmitteln ausgerüstet, die den Spannungsabfall an einem oder mehreren seiner nichtlinearen Teilwiderstände erfassen. Dabei ist der erfindungsgemäße Überspannungsableiter zum Anschluss an ein Hochspannungsnetz eingerichtet. Die Erfassung der Hochspannung durch übliche Spannungssensoren ist wegen der fehlenden Spannungsfestigkeit der Messgeräte in der Regel nicht möglich. Die Erfindung basiert auf der Idee, ohnehin im Ableiter vorhandene Spannungsteiler einzusetzen, um beispielsweise mit marktüblichen Messsensoren eine Hochspannung kostengünstig und zuverlässig zu überwachen. Voraussetzung hierfür ist selbstverständlich, dass aufgrund des erfassten Spannungsabfalls am Messwiderstand ein Rückschluss auf die zwischen Hochspannungs- und Erdspannungsanschluss des Überspannungsableiters abfallende Spannung möglich ist. Mit anderen Worten ist im Rahmen der Erfindung sowohl die Impedanz des Messwiderstands als auch die Impedanz der restlichen nichtlinearen Widerstände in Reihe zum Messwiderstand bekannt.

Die Ausgestaltung der Spannungserfassungsmittel ist grundsätzlich beliebig. Im einfachsten Fall sind die Spannungserfassungsmittel als elektrische Verbindungsleiter realisiert, mit dessen Hilfe das Potenzial, das an der vom Erdpotenzial abgewandten Seite des Messwiderstandes anliegt, aus dem Ableitergehäuse herausgeführt wird. Die Spannungserfassungsmittel können aber auch einen Spannungssensor umfassen, der im Inneren des Ableitergehäuses angeordnet ist und dessen Ausgangssignal von einer Signalleitung nach außen geführt wird. Die Signalleitung ist beispielsweise eine Kabel- oder Funkverbindung.

Zweckmäßigerweise ist der Messwiderstand der nichtlineare Teilwiderstand, der direkt mit dem Erdspannungsanschluss verbunden ist. Die an diesem Messwiderstand abfallende Spannung liegt daher im Bereich des Erdpotenzials, so dass aufwändige Messungen an Hochspannungspotenzialen im Rahmen dieser Weiterentwicklung vermieden sind.

Zweckmäßigerweise weisen alle nichtlinearen Teilwiderstände die gleiche Impedanz auf. Gemäß dieser vorteilhaften Weiterentwicklung ist eine besonders einfache Berechnung der schnellen transienten Überspannungen ermöglicht. Das Übersetzungsverhältnis ü lässt sich mit Hilfe von der folgenden Formel bestimmen:

$$\ddot{u} = U_H/U_N = (Z_H+Z_N) \ / \ Z_N = n,$$

wobei n der Anzahl der in Reihe geschalteten nichtlinearen Teilwiderstände, $Z_H$ der Impedanz des gesamten Ableiterstrompfads $Z_N$ der Impedanz des Messwiderstands, $U_H$ der gesamten am Überspannungsableiter abfallenden Hochspannung und $U_H$ der am Messwiderstand abfallenden Spannung entsprechen.

Zweckmäßigerweise sind die nichtlinearen Teilwiderstände zumindest teilweise scheibenförmig ausgebildet und liegen unter Ausbildung einer Ableitersäule flächig aneinander an, wobei Säulenhaltemittel einen Druckkontakt zwischen den aneinander anliegenden nichtlinearen Teilwiderständen bereitstellen. Als Säulenhaltemittel kommen beispielsweise in den Endarmaturen der Ableitersäule verpresste Zugstangen in Betracht. Aber auch anderen Säulenhaltemittel, mit denen ein ausreichend hoher Pressdruck zwischen Teilwiderständen erzeugbar ist, kann im Rahmen dieser Ausgestaltung der Erfindung eingesetzt werden.

Gemäß einer bevorzugten Variante der Erfindung sind die scheibenförmigen nichtlinearen Widerstände Varistorscheiben. Varistorscheiben sind als solche bekannt, so dass auf deren Eigenschaften und Ausgestaltungen an dieser Stelle nicht genauer eingegangen werden muss.

Vorteilhafterweise erstrecken sich die Spannungserfassungsmittel zumindest teilweise in einer Ausnehmung des Messwiderstandes. Gemäß dieser vorteilhaften Weiterentwicklung erfolgt die Spannungsmessung innerhalb eines magnetisch feldfreien Raums des jeweiligen nichtlinearen Widerstandes. Dadurch werden magnetisch induzierte Störspannungen vermieden und das Signal-Rausch-Verhältnis der Messung wird erheblich verbessert. Im Rahmen dieser Weiterentwicklung ist daher eine genauere Messung der schnellen transienten Überspannungen ermöglicht.

Vorteilhafterweise ist am Messwiderstand wenigstens eine Metallscheibe angeordnet. Die Metallscheibe stellt zum einen einen guten elektrischen Kontakt zwischen dem Messwiderstand und den restlichen Teilwiderständen des nichtlinearen Widerstandes bereit. Darüber hinaus ist es möglich, den Messwiderstand mit der Metallscheibe mechanisch zu verbinden, so dass eine Halterung des Messwiderstandes bereitgestellt ist.

Zweckmäßigerweise ist eine Sensorschutzeinheit den Spannungserfassungsmitteln parallel geschaltet. Eine Sensorschutzeinheit ist beispielsweise eine Funkenstrecke oder ein sonstiger nichtlinearer Widerstand, der bei Überschreiten einer an ihm abfallenden Schwellenspannung eine hohe Leitfähigkeit annimmt und so die parallel angeordneten Spannungserfassungsmittel überbrückt. Mit anderen Worten stellt die Sensorschutzeinheit einen Spannungsschutz für die Spannungserfassungsmittel bereit.

Vorteilhafterweise umfassen die Spannungserfassungsmittel eine außerhalb des Ableitergehäuses angeordnete Steckverbindung. Die Steckverbindung kann außerhalb des Ableitergehäuses auf einfache Art und Weise mit Hilfe üblicher Spannungssensoren kontaktiert und die an ihr abfallende Spannung somit erfasst werden. Dabei weisen die Spannungserfassungsmittel eine durch das Ableitergehäuse hindurch geführte elektrische Verbindungsleitung auf, die über einen Innenleiter verfügt, der mit der erdpotenzialfreien Seite des Messwiderstands verbunden ist.

Zweckmäßigerweise ist das Ableitergehäuse ein druckfestes fluiddichtes Gehäuse auf Erdpotenzial. Aufgrund der druckfesten Ausgestaltung des Gehäuses, kann dieses mit einem Schutzgas befüllt werden, das mit einem Druck beaufschlagt ist, der größer als der Atmosphärendruck ist. Aufgrund dieses Überdrucks ist die Spannungsfestigkeit erhöht. Mit dem Begriff "fluiddicht" ist gemeint, dass das Gehäuse sowohl gasdicht als auch dicht für Flüssigkeiten ausgestaltet ist. Bei einer anderen Variante der Erfindung besteht das Gehäuse aus Porzellan. Auch Gehäuse mit einer äußeren Silikonschicht können im Rahmen der Erfindung eingesetzt werden. Der erfindungsgemäße Überspannungsleiter ist beispielsweise in der Freiluft aufgestellt. Hiervon abweichend wird der Überspannungsableiter mit seinem Gehäuse an eine durch Schutzgas isolierte Anlage angeflanscht. Das Ableitergehäuse ist dann mit dem Innenraum der Anlage, beispielsweise einer Hochspannungsschaltanlage, verbunden.

Zweckmäßigerweise ist in dem Ableiterstrompfad in Reihe zum nichtlinearen Widerstand eine Trenneinrichtung angeordnet. Mit Hilfe der Trenneinrichtung ist es möglich, den Überspannungsableiter vom Spannungsversorgungsnetz abzuschalten. Dies ist beispielsweise dann erforderlich, wenn in dem Netz angeordnete Hochspannungsgeräte, zu dessen Schutz der angeschlossene Überspannungsableiter dient, getestet werden müssen. Die dabei aufgeprägten Testspannungen würden durch den Überspannungsableiter verfälscht. Aus diesem Grunde ist es zweckmäßig, den Überspannungsableiter vom Versorgungsnetz abzutrennen.

Gemäß einer Variante der Erfindung ist der Messwiderstand außerhalb des Ableitergehäuses angeordnet. Gemäß dieser vorteilhaften Weiterentwicklung der Erfindung ist es möglich, bereits installierte Überspannungsableiter mit Spannungserfassungsmitteln nachzurüsten.

Weiterhin kann es vorteilhaft sein, dass in dem Ableiterstrompfad eine Stromerfassungseinheit angeordnet ist. Mit Hilfe der Stromerfassungseinheit kann der über den Ableiterstrompfad fließende Strom erfasst werden.

Die Erfindung löst die Aufgabe auch durch ein Verfahren zum Messen einer an einem Überspannungsableiter abfallenden Hochspannung, bei dem ein nichtlinearer Teilwiderstand auf Erdpotenzial mit bekannter Impedanz mit einem Ableitergehäuse des Überspannungsableiters unter Ausbildung eines Messwiderstands verbunden wird, die an den Messwiderstand abfallende Spannung als Messspannung $U_N$ erfasst und die an dem Überspannungsableiter abfallende Hochspannung aus der Messspannung abfallende Spannung berechnet wird.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei

Figur 1     ein Ausführungsbeispiel des erfindungsgemäßen Überspannungsableiters in einer schematischen Seitenansicht,

Figur 2     ein weiteres Ausführungsbeispiel des erfindungsgemäßen Überspannungsableiters in einer schematischen Seitenansicht,

Figur 3     ein Ausführungsbeispiel des nichtlinearen Widerstandes,

Figur 4     eine entlang der Linie A-B in Figur 4 geschnittene Ansicht des Messwiderstandes und

Figur 5     ein weiteres Ausführungsbeispiel des erfindungsgemäßen Überspannungsableiters in einer schematischen Seitenansicht verdeutlichen.

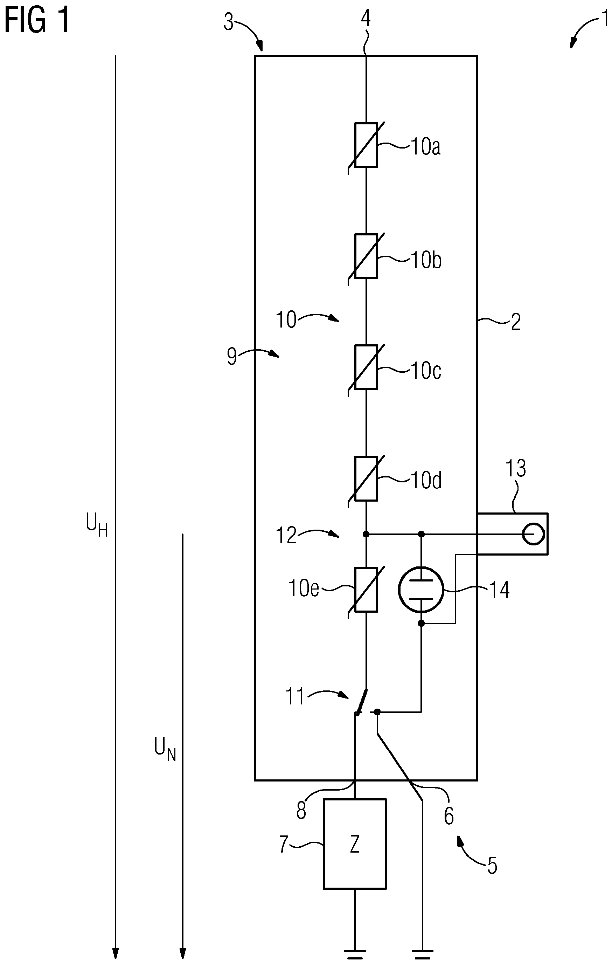

Figur 1 zeigt ein Ausführungsbeispiel des erfindungsgemäßen Überspannungsableiters 1 in einer schematischen Seitenansicht. Der Überspannungsableiter 1 weist ein druckfestes und fluiddichtes Ableitergehäuse 2 auf Erdpotenzial auf, das eine Hochspannungsseite 3 mit einem Hochspannungsanschluss 4 sowie eine Erdpotenzialseite 5 mit einem Erdpotenzialanschluss 6 aufweist. Der Hochspannungsanschluss 4 ist in einem elektrisch nicht leitenden Deckel des Ableitergehäuses 2 angeordnet. Darüber hinaus ist ein Blitzzähler 7 vorgesehen, der an einem Blitzzähleranschluss 8 des Ableitergehäuses 2 an dessen Erdpotenzialseite 5 angeschlossen ist. Der Blitzzähler 7 liegt darüber hinaus ebenfalls auf Masse. Der Hochspannungsanschluss 4 und der Blitzzähleranschluss 8 sind über einen Ableiterstrompfad 9 miteinander verbunden, der sich innerhalb des Ableitergehäuses 2 erstreckt. Im Ableiterstrompfad 9 ist ein nichtlinearer Widerstand 10 vorgesehen, der aus in Reihe zueinander geschalteten Teilwiderständen 10a, 10b, 10c, 10d und 10e besteht. In Reihe zum nichtlinearen Widerstand 10 ist eine Trennschalteinheit 11 angeordnet, mit deren Hilfe es möglich ist, den nichtlinearen Widerstand 10 wahlweise mit dem Erdpotenzialanschluss 6 oder dem Blitzzähleranschluss 8 zu verbinden. Darüber hinaus sind Spannungserfassungsmittel 12 angedeutet, die eine außerhalb des Ableitergehäuses 2 angeordnete Steckverbindung 13 aufweisen. An dem Anschluss der Steckverbindung 13 kann die an dem Messwiderstand 10e abfallende Spannung abgegriffen werden. Der Teilwiderstand 10e ist mit dem Erdpotenzial direkt verbunden oder verbindbar und wird daher hier als Messwiderstand 10e bezeichnet. In Parallelschaltung zum Messwiderstand 10e ist innerhalb des Ableitergehäuses 2 eine Sensorschutzeinheit 14 vorgesehen, die als edelgasgefüllter Überspannungsableiter 14 ausgeführt ist.

Die nichtlinearen Teilwiderstände 10a, 10b, 10c, 10d und 10e weisen alle die gleiche Impedanz auf, so dass gemäß der bereits erläuterten Formel ü = $U_H$/$U_N$ = ($Z_H$+$Z_N$) / $Z_N$ = n aufgrund der am Messwiderstand 10e gemessenen Spannung $U_N$ auf die am gesamten Ableiter abfallende Spannung $U_H$ zurückgeschlossen werden kann. Mit anderen Worten kann die Hochspannung $U_H$ und somit auch schnelle transiente Überspannungen auf einfache Art und Weise an der koaxialen Steckverbindung 13 erfasst werden.

Der Überspannungsableiter 1 ist in den Figuren aus Gründen der Übersicht mit nur einer Phase dargestellt. Es sei hier jedoch darauf hingewiesen, dass der Überspsnanungsableiter 1 gemäß der Erfindung mehrere und bevorzugt drei identisch aufgebaute Phasen aufweist.

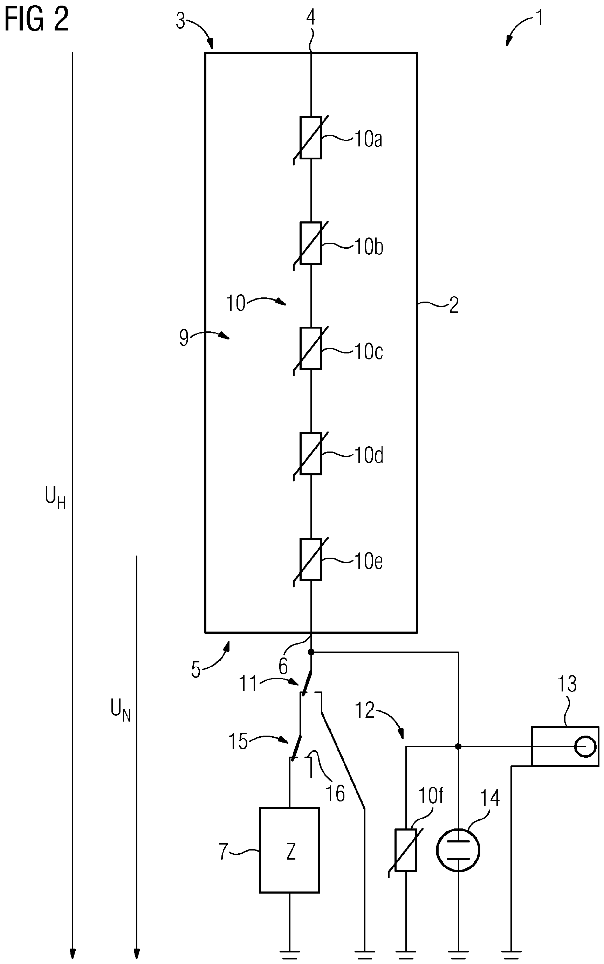

Figur 2 zeigt eine weitere Variante des erfindungsgemäßen Überspannungsableiters 1. Im Gegensatz zu dem in Figur 1 gezeigten Ausführungsbeispiel sind der Messwiderstand 10f, die Spannungserfassungsmittel 12, der Überspannungsableiter 14 und die Trenneinheit 11 außerhalb des Ableitergehäuses 2 angeordnet. Darüber hinaus ist in Reihe zur Trenneinheit 11 ein Sekundärschalter 15 erkennbar, der den Erdanschluss 6 des Ableitergehäuses mit einem Zusatzkontakt 16 verbinden kann. Mit Hilfe der Trenneinheit 11 ist es möglich, den Erdanschluss 6 direkt mit dem Erdpotenzial zu verbinden oder mit dem Blitzzähler 7. Wird der Sekundärschalter 15 an den Zusatzkontakt 16 gelegt, wird der Widerstand unendlich groß, so dass in dieser Stellung der Teilwiderstand 10f als Messwiderstand, den übrigen Teilwiderständen 10a, 10b, 10c, 10d und 10e zugeschaltet ist und so Teil des nichtlinearen Widerstandes 9 des Überspannungsleiters 1 wird. Der Teilwiderstand 10f wird so zum Messwiderstand.

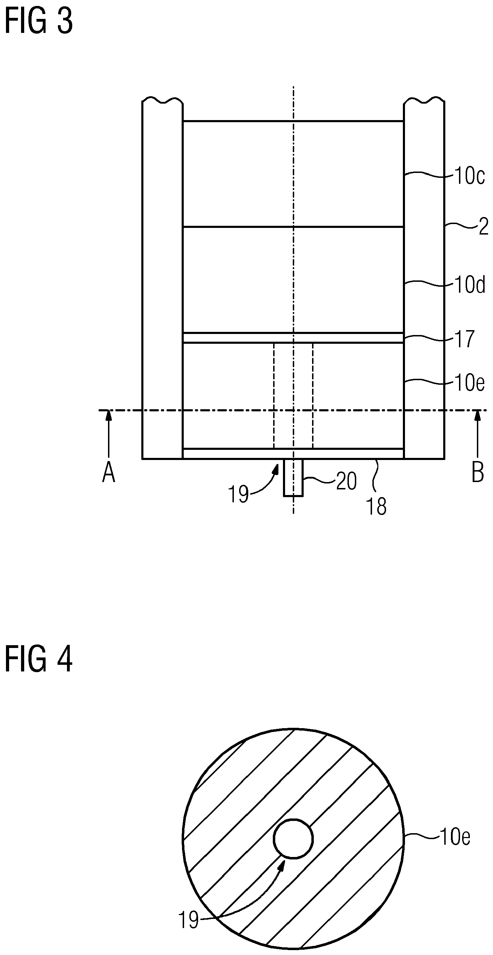

Figur 3 zeigt den nichtlinearen Widerstand gemäß der Figuren 1 und 2 in einer Seitenansicht genauer. Es ist erkennbar, dass die Teilwiderstände 10e, 10d, 10c und auch die in Figur 3 nicht gezeigten Teilwiderstände 10b und 10a aus kreiszylindrischen Varistorscheiben bestehen. Im Rahme der Erfindung kann die Varistorscheibe aber auch abweichend hiervon ausgestaltet und beispielsweise in einer Draufsicht viereckig sein. Der Messwiderstand ist beidseitig von Metallscheiben 17 und 18 umgeben, wobei die Metallscheibe 18 auf Erdpotenzial liegt. Innerhalb des Messwiderstands erstreckt sich eine Durchgangsöffnung 19 als mittige Ausnehmung. Ein Koaxialkabel 20 als Verbindungsleiter kann daher mit seinem Innenleiter an die Metallscheibe 17 angeschlossen und außen isoliert aus dem Messwiderstand 10e herausgeführt werden.

Figur 4 zeigt den Messwiderstand in einer entlang der Linie A-B in Figur 3 geschnittene Ansicht, in welcher die mittige Ausnehmung oder durchgehende Öffnung 19 besonders gut erkennbar ist. Aufgrund der mittigen Ausnehmung 19 ist eine magnetische Abschirmung bereitgestellt, so dass Messstörungen vermieden sind.

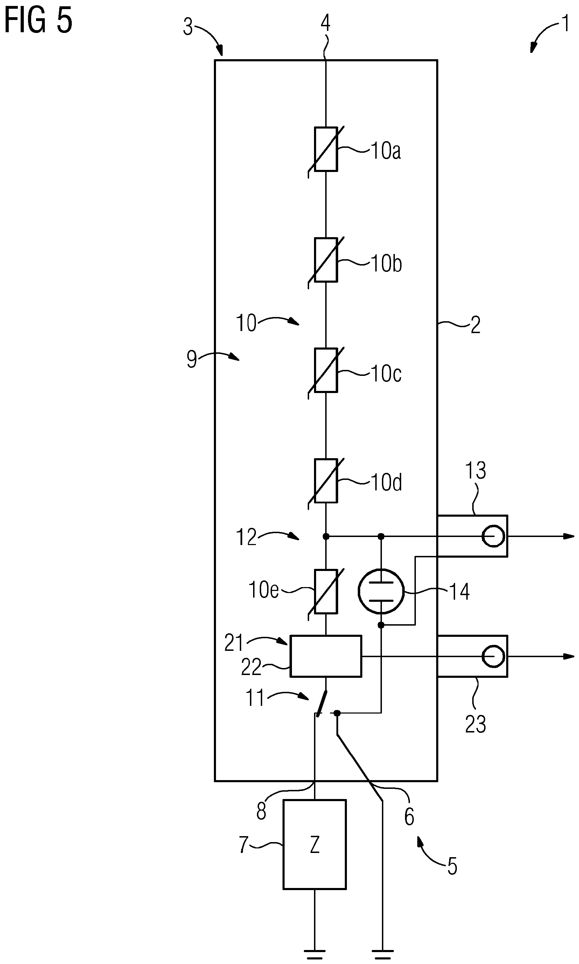

Figur 5 zeigt ein weiteres Ausführungsbeispiel des erfindungsgemäßen Überspannungsableiters 1, der im Wesentlichen dem Überspannungsableiter 1 gemäß Figur 1 entspricht, der jedoch neben den Spannungserfassungsmitteln 12 eine Strommesseinheit 21 im Ableiterstrompfad 9 aufweist, wobei die Strommesseinheit 21 zwischen dem Erdanschluss 6 und dem Messwiderstand 10e angeordnet ist. Die Strommesseinheit 21 verfügt ebenfalls über eine Steckverbindung 22, die über eine durch das Ableitergehäuse 2 geführte Kabelverbindung mit einem Stromsensor im Ableiterstrompfad verbunden ist.

Mit Hilfe der Erfindung kann an der koaxialen Steckbuchse 13 beispielsweise durch Anschluss eines Digitalrekorders oder eines Oszilloskops die am Messwiderstand 10e und somit dem Überspannungsableiter 1 abfallende Spannung erfasst werden. Falls die Spannung zu hoch ist, kann ein weiterer externer Widerstand verwendet werden. Bei einer Messung wird durch den rasch veränderlichen Strom im Varistor ein Magnetfeld um den Varistor aufgebaut, so dass eine Störspannung in der Messschleife induzieren kann. Diese Störspannung kann durch die Ausnehmung vermieden werden, da diese innerhalb eines magnetisch feldfreien Raums abgegriffen wird. Dadurch werden magnetisch induzierte Störspannungen eliminiert und das Signal-Rausch-Verhältnis erheblich verbessert.

Bei einer schnellen transienten Überspannung kann im Überspannungsableiter ein Impulsstrom fließen, der mit Hilfe des Stromsensors 21 an der Anschlussbuchse abgegriffen werden kann.

**Patentansprüche**

1. Überspannungsableiter (1) zum Schutz elektronischer Hochspannungsgeräte mit

   - einem Ableitergehäuse (2),
   - einem Hochspannungsanschluss (4) und einem Erdspannungsanschluss (6), die über einen Ableiterstrompfad (9) miteinander verbindbar sind, und
   - einem in dem Ableiterstrompfad (9) angeordneten nichtlinearen Widerstand (10), der aus einer Reihenschaltung nichtlinearer Teilwiderstände (10a,10b,10c,10d,10e) gebildet ist,

   **gekennzeichnet durch** Spannungserfassungsmittel (12), die zum Erfassen einer an einem Messwiderstand (10e,10f) abfallenden Spannung eingerichtet sind, wobei der Messwiderstand (10e,10f) aus einem oder mehreren nichtlinearen Teilwiderständen gebildet ist.

2. Überspannungsableiter (1) nach Anspruch 1, **dadurch gekennzeichnet, dass** der Messwiderstand der nichtlineare Teilwiderstand (10e,10f) ist, der direkt mit dem Erdspannungsanschluss (9) verbundenen oder verbindbar ist.

3. Überspannungsableiter (1) nach einem der vorhergehenden Ansprüche, **dadurch gekennzeichnet, dass** die alle nichtlinearen Teilwiderstände (10a,10b,10c,10d,10e,10f) die gleiche Impedanz aufweisen.

4. Überspannungsableiter (1) nach einem der vorhergehenden Ansprüche, **dadurch gekennzeichnet, dass** die nichtlinearen Teilwiderstände (10a,10b,10c,10d,10e,10f) zumindest teilweise scheibenförmig ausgebildet sind und unter Ausbildung einer Ableitersäule flächig aneinander anliegen, wobei Säulenhaltemittel einen Druckkontakt zwischen den aneinander anliegenden nichtlinearen Teilwiderständen (10a,10b,10c, 10d,10e,10f) bereitstellen.

5. Überspannungsableiter (1) nach Anspruch 4, **dadurch gekennzeichnet, dass** die scheibenförmigen nichtlinearen Teilwiderstände (10a,10b,10c, 10d,10e,10f) Varistorscheiben sind.

6. Überspannungsableiter (1) nach einem der vorhergehenden Ansprüche, **dadurch gekennzeichnet, dass** die Spannungserfassungsmittel (12) sich zum Teil in einer Ausnehmung des Messwiderstandes (10e,10f) erstrecken.

7. Überspannungsableiter (1) nach Anspruch 6, **dadurch gekennzeichnet, dass** an dem Messwiderstand (10e,10f) wenigstens eine Metallscheibe (17,18) angeordnet ist.

8. Überspannungsableiter (1) nach einem der vorhergehenden Ansprüche, **gekennzeichnet durch** eine Sensorschutzeinheit (14) in Parallelschaltung zu den Spannungserfassungsmitteln (12).

9. Überspannungsableiter (1) nach einem der vorhergehenden Ansprüche,

**dadurch gekennzeichnet, dass** die Spannungserfassungsmittel (12) eine außerhalb des Ableitergehäuses angeordnete Steckverbindung (13) aufweisen.

10. Überspannungsableiter (1) nach einem der vorhergehenden Ansprüche,
**dadurch gekennzeichnet, dass** das Ableitergehäuse (2) ein druckfestes fluiddichtes Gehäuse auf Erdpotenzial ist.

11. Überspannungsableiter (1) nach einem der vorhergehenden Ansprüche,
**gekennzeichnet durch**
eine in Reihe zum nichtlinearen Widerstand (10) in dem Ableiterstrompfad (9) angeordnete Trennschalteinrichtung (11).

12. Überspannungsableiter (1) nach einem der vorhergehenden Ansprüche,
**dadurch gekennzeichnet, dass** der Messwiderstand (10f) außerhalb des Ableitergehäuses (2) angeordnet ist.

13. Überspannungsableiter (1) nach einem der vorhergehenden Ansprüche,
**gekennzeichnet durch**
eine im Ableiterstrompfad (9) angeordnete Stromerfassungseinheit (21).

14. Verfahren zum Messen einer an einem Überspannungsableiter abfallenden Hochspannung, bei dem

- ein nichtlinearer Teilwiderstand auf Erdpotenzial mit bekannter Impedanz mit einem Ableitergehäuse des Überspannungsableiters unter Ausbildung eines Messwiderstands verbunden wird,
- die an den Messwiderstand (10f) abfallende Spannung als Messspannung $U_N$ erfasst und
- die an dem Überspannungsableiter (1) abfallende Hochspannung aus der Messspannung $U_N$ berechnet wird.

FIG 1

$U_H$

$U_N$

FIG 2

## FIG 3

- 10c
- 2
- 10d
- 17
- 10e

A

19
20
18

B

## FIG 4

10e

19

# FIG 5

Europäisches Patentamt

European Patent Office

Office européen des brevets

# EUROPÄISCHER RECHERCHENBERICHT

Nummer der Anmeldung

EP 17 15 4841

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 439 548 A1 (ABB RESEARCH LTD [CH]) 21. Juli 2004 (2004-07-21) * Absätze [0018] - [0021], [0025], [0027], [0028], [0030], [0032], [0033]; Abbildungen 1-7 * ----- | 1-14 | INV. H01C7/12 G01R15/16 |
| X | EP 0 462 694 A2 (ELECTRIC POWER RES INST [US]) 27. Dezember 1991 (1991-12-27) * Spalte 3, Zeile 50 - Spalte 4, Zeile 13 * * Spalte 6, Zeilen 5-23; Abbildungen 1,2 * * Spalte 7, Zeilen 4-22 * ----- | 1,14 | |
| A | WO 2015/139893 A1 (DEHN & SÖHNE GMBH & CO KG [DE]) 24. September 2015 (2015-09-24) * Seite 6, Zeilen 20-30; Abbildung 1 * ----- | 8 | |
| A | EP 2 466 596 A1 (ABB RESEARCH LTD [CH]) 20. Juni 2012 (2012-06-20) * Absätze [0001] - [0005], [0022] - [0036]; Abbildung 1 * ----- | 11,13 | RECHERCHIERTE SACHGEBIETE (IPC) H01C H02H G01R |

Der vorliegende Recherchenbericht wurde für alle Patentansprüche erstellt

| Recherchenort | Abschlußdatum der Recherche | Prüfer |
|---|---|---|
| Berlin | 13. Juli 2017 | Pantelidis, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 17 15 4841

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-07-2017

| Im Recherchenbericht angeführtes Patentdokument | Datum der Veröffentlichung | Mitglied(er) der Patentfamilie | Datum der Veröffentlichung |
|---|---|---|---|
| EP 1439548 A1 | 21-07-2004 | KEINE | |
| EP 0462694 A2 | 27-12-1991 | CA 2040163 A1<br>EP 0462694 A2 | 22-12-1991<br>27-12-1991 |
| WO 2015139893 A1 | 24-09-2015 | CN 106463304 A<br>DE 202014002496 U1<br>DE 202014003832 U1<br>EP 3120372 A1<br>US 2017110226 A1<br>WO 2015139893 A1 | 22-02-2017<br>17-04-2014<br>20-05-2014<br>25-01-2017<br>20-04-2017<br>24-09-2015 |
| EP 2466596 A1 | 20-06-2012 | CN 102565639 A<br>EP 2466596 A1<br>JP 2012127968 A<br>KR 20120067961 A<br>RU 2011151383 A<br>US 2012153976 A1 | 11-07-2012<br>20-06-2012<br>05-07-2012<br>26-06-2012<br>20-06-2013<br>21-06-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012217310 A1